(19) Europäisches Patentamt
European Patent Office
Office européen des brevets

(11) **EP 4 100 992 B1**

(12) **EUROPÄISCHE PATENTSCHRIFT**

(45) Veröffentlichungstag und Bekanntmachung des Hinweises auf die Patenterteilung:
**11.03.2026 Patentblatt 2026/11**

(21) Anmeldenummer: **21704216.7**

(22) Anmeldetag: **05.02.2021**

(51) Internationale Patentklassifikation (IPC):
*H01L 21/20* *(2006.01)*

(52) Gemeinsame Patentklassifikation (CPC):
**H10P 14/3256; H10P 14/2905; H10P 14/3208; H10P 14/3211; H10P 14/3251; H10P 14/3408; H10P 14/3411; H10P 14/36**

(86) Internationale Anmeldenummer:
**PCT/EP2021/052774**

(87) Internationale Veröffentlichungsnummer:
**WO 2021/156422 (12.08.2021 Gazette 2021/32)**

(54) **VERFAHREN ZUR HERSTELLUNG EINER HALBLEITERSTRUKTUR**

METHOD FOR PRODUCING A SEMICONDUCTOR STRUCTURE

PROCÉDÉ DE FABRICATION D'UNE STRUCTURE SEMI-CONDUCTRICE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.02.2020 DE 102020103197**

(43) Veröffentlichungstag der Anmeldung:
**14.12.2022 Patentblatt 2022/50**

(73) Patentinhaber: **Fraunhofer-Gesellschaft zur Förderung der angewandten Forschung e.V. 80686 München (DE)**

(72) Erfinder:
• **JANZ, Stefan**
**79110 Freiburg (DE)**
• **BETT, Andreas**
**79110 Freiburg (DE)**

(74) Vertreter: **LBP Lemcke, Brommer & Partner Patentanwälte mbB Siegfried-Kühn-Straße 4 76135 Karlsruhe (DE)**

(56) Entgegenhaltungen:
**WO-A2-2005/087983 US-A1- 2005 263 754**

• **SEVERINO ANDREA ET AL: "Heteroepitaxial Growth of 3C-SiC on Silicon-Porous Silicon-Silicon (SPS) Substrates", ECS TRANSACTIONS, vol. 3, no. 5, 21 December 2019 (2019-12-21), pages 287 - 298, XP055800945, Retrieved from the Internet <URL:https://iopscience.iop.org/article/10.1149/1.2357217> DOI: 10.1149/1.2357217**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Verfahren zur Herstellung einer Halbleiterstruktur gemäß Oberbegriff des Anspruchs 1.

Für eine Vielzahl von Anwendungen ist es wünschenswert, mehrere Schichten von Halbleitermaterialien mit unterschiedlichen Materialparametern übereinander anzuordnen. Eine gängige Lösung ist das Erzeugen der Halbleiterschichten mittels Epitaxie, der Prozess des Aufbringens mehrerer aufeinanderfolgender Schichten mit unterschiedlichen Materialparametern, insbesondere unterschiedlichen Gitterkonstanten wird als Heteroepitaxie bezeichnet.

Bei einem solchen Schichtsystem führen Unterschiede in der Materialeigenschaft, insbesondere unterschiedliche Gitterkonstanten und thermische Ausdehnungskoeffizienten der einzelnen Halbleiterschichten zu Verspannungen und Kristallfehlern, insbesondere in den epitaktisch gewachsenen Schichten. Hierdurch wird die Materialqualität verringert.

Die Halbleiterschichten werden typischerweise auf einem Halbleitersubstrat aufgebracht. Bei der Heteroepitaxie auf einem Halbleitersubstrat können zusätzlich zu den vorgenannten Nachteilen auch im Halbleitersubstrat Verspannungen und Kristallfehler durch den Epitaxieprozess auftreten.

Das heteroepitaktische Abscheiden von Halbleiterschichten auf einem Halbleitersubstrat ist an sich bekannt und wird beispielsweise bei der Herstellung von photovoltaischen Solarzellen verwendet. Aus Feifel, Markus et al. "Direct growth of III-V/silicon triple-junction solar cells with 19.7% efficiency", IEEE Journal of Photovoltaics 8 (2018), No.6, pp.1590-1595 ist das direkte Aufbringen von GaP auf einer glatten Si Waferoberfläche und aus La Via, et al., "Patterned substrate with inverted silicon pyramids for 3C-SiC epitaxial growth: A comparison with conventional (001) Si substrate", Journal of Materials Research, 28(1), 94-103. doi:10.1557/jmr.2012.268 ist das epitaktische Aufbringen einer Siliziumcarbidschicht auf einer mittels invertierten Pyramiden strukturierten Oberfläche eines Siliziumwafers bekannt.

EVERINO ANDREA ET AL: "Heteroepitaxial Growth of 3C-SiC on Silicon-Porous Silicon-Silicon (SPS) Substrates",ECS TRANSACTIONS,Bd. 3, Nr. 5 21. Dezember 2019, Seiten 287-298,DOI: 10.1149/1.2357217 offenbart ein Verfahren zur Herstellung einer Halbleiterstruktur gemäß der Präambel von Anspruch 1.

Der vorliegenden Erfindung liegt daher die Aufgabe zugrunde, eine Halbleiterstruktur für ein Halbleiterbauelement und ein Verfahren zur Herstellung einer solchen Halbleiterstruktur mit einem Halbleitersubstrat und zumindest einer Halbleiterschicht zur Verfügung zu stellen, wobei Halbleiterschicht und Halbleitersubstrat unterschiedliche Materialparameter aufweisen und das Risiko einer Materialbeeinträchtigung gegenüber vorbekannten Verfahren verringert ist.

Gelöst ist diese Aufgabe durch ein Verfahren zur Herstellung einer Halbleiterstruktur gemäß Anspruch 1. Vorteilhafte Ausgestaltungen finden sich in den abhängigen Ansprüchen.

Die Halbleiterstruktur wird bevorzugt mittels des erfindungsgemäßen Verfahrens, insbesondere einer bevorzugten Ausführungsform hiervon, hergestellt. Das erfindungsgemäße Verfahren ist bevorzugt zur Herstellung der erfindungsgemäßen Halbleiterstruktur, insbesondere einer bevorzugten Ausführungsform hiervon, ausgebildet.

Die Halbleiterstruktur für ein Halbleiterbauelement weist eine Halbleiterschicht zum Ausbilden zumindest eines Halbleiterbauelementes auf, welche mittelbar auf einem Halbleitersubstrat angeordnet ist.

Wesentlich ist, dass zwischen Halbleitersubstrat und Halbleiterschicht ausgehend von dem Halbleitersubstrat zumindest die folgenden Schichten in der angegebenen Reihenfolge A, B, C mit oder bevorzugt ohne Zwischenschaltung weiterer Schichten angeordnet sind

A. eine hochporöse Schicht (3) mit einer Porosität größer 50% und einer Dicke im Bereich 0,1 $\mu$m bis 1 $\mu$m,

B. eine funktionale Zwischenschicht (4) mit einer Porosität im Bereich 5% bis 90% und einer Dicke im Bereich 0,1 $\mu$m bis 5 $\mu$m,

C. eine geschlossene Wachstumsvorlageschicht (6) mit einer Porosität kleiner 5%, insbesondere kleiner 1% und einer Dicke im Bereich 1 nm bis 100 nm, wobei die geschlossene Wachstumsvorlageschicht (6) eine Gitterkonstante aufweist, welche um weniger als 10%, bevorzugt weniger als 5%, insbesondere weniger als 2% von der Gitterkonstante der Halbleiterschicht (2) abweicht.

Weiterhin weisen das Halbleitersubstrat und die Halbleiterschicht eine um zumindest ein Massenprozent abweichende stoffliche Zusammensetzung auf, das Halbleitersubstrat und die Halbleiterschicht weisen eine unterschiedliche Gitterkonstante auf und das Halbleitersubstrat und die Halbleiterschicht sind über die dazwischenliegenden Schichten elektrisch leitend verbunden.

Halbleitersubstrat, hochporöse Schicht und funktionale Zwischenschicht weisen eine Dotierung mit dem gleichen Dotierstoff auf, insbesondere im Wesentlichen die gleiche Dotierkonzentration auf. Dies ist darin begründet, dass bei der Herstellung zumindest die Schichten hochporöse Schicht und die funktionale Zwischenschicht aus dem Halbleitersubstrat ausgebildet werden, wie weiter unten erläutert. Bevorzugt wird auch die geschlossene Wachstumsvorlageschicht aus dem Halbleitersubstrat ausgebildet. Daher weist bevorzugt auch die geschlossene Wachstumsvorlageschicht eine Dotierung mit dem gleichen Dotierstoff wie das Halbleitersubstrat auf, insbesondere eine im Wesentlichen gleiche Dotierkonzentration wie das Halbleitersubstrat.

Es ist ferner wesentlich, dass die Halbleiterschicht als epitaktisch unmittelbar auf die geschlossene Wachstumsvorlageschicht aufgebrachte Schicht ausgebildet ist, und dass auf der dem Halbleitersubstrat abgewandten Seite der funktionalen Zwischenschicht 4 mit oder bevorzugt ohne Zwischenschaltung weiterer Schichten eine poröse Wachstumsvorlageschicht mit einer Porosität im Bereich 5% bis 30% und einer Dicke im Bereich 1 nm bis 5 $\mu$m, bevorzugt im Bereich 10 nm bis 3 $\mu$m, ausgebildet ist, und dass die geschlossene Wachstumsvorlageschicht mittels Wärmeeinwirkung aus einem dem Halbleitersubstrat abgewandten Teilbereich der porösen Wachstumsvorlageschicht ausgebildet ist und die Wärmeeinwirkung zur Ausbildung der geschlossenen Wachstumsvorlageschicht in einer Prozessatmosphäre, welche zumindest eines der Gase aus der Liste Wasserstoff, Argon, kohlenstoff-enthaltendes Gas, insbesondere Methan, Germanium enthaltendes Gas, enthält, durchgeführt ist.

Die vorliegende Erfindung ist in der Erkenntnis begründet, dass durch ein Schichtsystem, welches zwischen Halbleitersubstrat und Halbleiterschicht angeordnet ist und zumindest die oben genannten drei Schichten A bis C aufweist, das Risiko von Kristallfehlern und Verspannungen in der Halbleiterschicht und auch im Halbleitersubstrat gegenüber vorbekannten mittels Heteroepitaxie hergestellten Halbleiterstrukturen verringert ist. Mittels der Schichten A bis C kann insbesondere aufgrund der unterschiedlichen Porositäten der hochporösen Schicht A gegenüber der geschlossenen Wachstumsvorlageschicht C sowie aufgrund der Porosität der funktionalen Zwischenschicht B besser als bei vorbekannten Strukturen entstehender Stress sowie Unterschiede in den thermischen Ausdehnungskoeffizienten zwischen dem Material des Halbleitersubstrats und dem Material der Halbleiterschicht ausgeglichen werden.

Die geschlossene Wachstumsvorlageschicht weist bevorzugt eine Gitterkonstante auf, welche einen geringeren Unterschied zu der Gitterkonstante der Halbleiterschicht aufweist, verglichen mit dem Unterschied der Gitterkonstante des Halbleitersubstrats zu der Gitterkonstante der Halbleiterschicht, insbesondere einen um zumindest 10%, bevorzugt um zumindest 20%, insbesondere um zumindest 30% geringeren Unterschied.

Die eingangs erwähnte Aufgabe ist durch ein Verfahren zur Herstellung einer Halbleiterstruktur gemäß Anspruch 1 gelöst.

Das erfindungsgemäße Verfahren zur Herstellung einer Halbleiterstruktur mit einem Halbleitersubstrat und einer mittelbar auf dem Halbleitersubstrat angeordneten Halbleiterschicht weist die folgenden Verfahrensschritte auf:

I. Bereitstellen des Halbleitersubstrats,
II. Ausbilden einer Halbleiterschicht an einer Oberfläche des Halbleitersubstrats mittels Gasphasenabscheidung.

Wesentlich ist, dass zwischen den Verfahrensschritten I und II an zumindest einer Oberfläche des Halbleitersubstrats zumindest die folgenden Schichten in der Reihenfolge A, B, C mit oder bevorzugt ohne Zwischenschaltung weiterer Schichten ausgebildet werden:

A. eine hochporöse Schicht (3) mit einer Porosität größer 50% und einer Dicke im Bereich 0,1 $\mu$m bis 1 $\mu$m,
B. eine funktionale Zwischenschicht (4) mit einer Porosität im Bereich 5% bis 90% und einer Dicke im Bereich 0,1 $\mu$m bis 5 $\mu$m,
C. eine geschlossene Wachstumsvorlageschicht (6) mit einer Porosität kleiner 5%, insbesondere kleiner 1% und einer Dicke im Bereich 1 nm bis 100 nm,

wobei die geschlossene Wachstumsvorlageschicht eine Gitterkonstante aufweist, welche um weniger als 10%, insbesondere weniger als 5%, bevorzugt weniger als 1% von der Gitterkonstante der Halbleiterschicht (2) abweicht,
wobei die Halbleiterschicht auf der geschlossenen Wachstumsschicht - gegebenenfalls unter Zwischenschaltung weiterer Schichten - abgeschieden wird, dass die Halbleiterschicht mit einer zu dem Halbleitersubstrat um zumindest 1 Massenprozent abweichenden stofflichen Zusammensetzung ausgebildet wird, dass die Halbleiterschicht mit einer zu dem Halbleitersubstrat abweichenden Gitterkonstante ausgebildet wird und dass die Halbleiterschicht über die dazwischenliegenden Schichten mit dem Halbleitersubstrat elektrisch leitend verbunden ausgebildet wird. Die oben angegebenen Werte bzw. Unterschiede in der Gitterkonstante der geschlossenen Wachstumsvorlageschicht beziehen sich auf den Zustand, in welchem die Halbleiterschicht aufgebracht ist.

Erfindungsgemäß werden zumindest die hochporöse Schicht, die funktionale Zwischenschicht und die poröse Wachstumsvorlageschicht mittels Ätzen in dem Halbleitersubstrat ausgebildet.

Es ist ferner wesentlich, dass die Halbleiterschicht als epitaktisch unmittelbar auf die geschlossene Wachstumsvorlageschicht aufgebrachte Schicht ausgebildet wird und dass auf der dem Halbleitersubstrat abgewandten Seite der funktionalen Zwischenschicht 4 mit oder bevorzugt ohne Zwischenschaltung weiterer Schichten eine poröse Wachstumsvorlageschicht mit einer Porosität im Bereich 5% bis 30% und einer Dicke im Bereich 1 nm bis 5 $\mu$m, bevorzugt im Bereich 10 nm bis 3 $\mu$m, ausgebildet wird und dass die geschlossene Wachstumsvorlageschicht mittels Wärmeeinwirkung aus einem dem Halbleitersubstrat abgewandten Teilbereich der porösen Wachstumsvorlageschicht ausgebildet wird und dass die Wärmeeinwirkung zur Ausbildung der geschlossenen Wachstumsvorlageschicht in einer Prozessatmosphäre, welche zumindest eines der Gase aus der Liste Wasserstoff, Argon, kohlenstoff-enthaltendes Gas, insbesondere Methan, kohlenstoff-enthaltendes Germanium enthaltendes Gas, enthält, durchgeführt wird.

Hierdurch werden die zuvor genannten Vorteile erzielt.

Die Halbleiterschicht wird bevorzugt epitaktisch abgeschieden und insbesondere bevorzugt epitaktisch unmittelbar auf die Wachstumsvorlageschicht aufgebracht. Hierdurch kann auf an sich bekannte Methoden und Vorrichtungen zur epitaktischen Abscheidung zurückgegriffen werden.

Vorteilhafterweise sind hochporöse Schicht, funktionale Zwischenschicht, die nachfolgend beschriebene poröse Wachstumsvorlageschicht und/oder geschlossene Wachstumsvorlageschicht zu zumindest 50 Massenprozent, bevorzugt zumindest 95 Massenprozent aus dem Material des Halbleitersubstrats ausgebildet. Hierdurch ergibt sich der Vorteil einer vereinfachten Prozessführung.

Eine besonders vorteilhaft einfache Prozessführung ergibt sich bei dem erfindungsgemäßen Verfahren, da zumindest die hochporöse Schicht, die funktionale Zwischenschicht und die poröse Wachstumsvorlageschicht mittels Ätzen in dem Halbleitersubstrat ausgebildet werden, insbesondere bevorzugt mittels elektrochemischem Ätzen. Hierdurch kann einerseits auf an sich bekannte Methoden zum Herstellen poröser Schichten aus einem Halbleitersubstrat mittels Ätzen zurückgegriffen werden. Weiterhin müssen keine zusätzlichen Materialien zum Ausbilden der genannten Schichten aufgebracht werden. Die Schichten hochporöse Schicht, die funktionale Zwischenschicht und die poröse Wachstumsvorlageschicht werden somit nicht auf das Halbleitersubstrat aufgebracht, insbesondere nicht auf dem Halbleitersubstrat abgeschieden, sondern aus dem Material des Halbleitersubstrats ausgebildet.

Bei Ausbilden der porösen Schichten mittels Ätzen, insbesondere mittels elektrochemischem Ätzen erfolgt bevorzugt ein Erzeugen der Schichten ausgehend von derjenigen Oberfläche, an welcher die Halbleiterschicht abgeschieden werden soll. Daher wird bevorzugt die funktionale Zwischenschicht vor der hochporösen Schicht erzeugt. Die geschlossene Wachstumsvorlageschicht wird bevorzugt nach Erzeugen der funktionalen Zwischenschicht erzeugt.

In der vorteilhaften Ausführungsform mit Erzeugen einer porösen Wachstumsvorlageschicht wird dies bevorzugt vor Erzeugen der funktionalen Zwischenschicht ausgebildet. Die geschlossene Wachstumsvorlageschicht wird in diesem Fall bevorzugt nach Erzeugen der porösen Wachstumsvorlageschicht erzeugt.

Das Halbleitersubstrat weist bevorzugt einen geringen Schichtwiderstand auf. Dies ist insbesondere vorteilhaft, in Kombination mit Ausbilden einer oder mehrerer der porösen Schichten mittels elektrochemischen Ätzen. Vorteilhafterweise weist das Halbleitersubstrat daher einen Schichtwiderstand kleiner 500 mΩcm, bevorzugt kleiner 100 mΩcm, insbesondere kleiner 10 mΩcm auf.

Das Halbleitersubstrat weist bevorzugt eine Dotierung mit einem Dotierstoff des p-Typs oder des n-Typs auf. Da zumindest die Schichten hochporöse Schicht, die funktionale Zwischenschicht und die poröse Wachstumsvorlageschicht mittels Ätzen in dem Halbleitersubstrat ausgebildet werden, weisen bevorzugt zumindest die Schichten hochporöse Schicht, die funktionale Zwischenschicht und die poröse Wachstumsvorlageschicht eine Dotierung mit dem gleichen Dotierstoff auf wie das Halbleitersubstrat, insbesondere mit der im wesentlichen gleichen Dotierkonzentration wie das Halbleitersubstrat.

Untersuchungen der Erfinder zeigen, dass vorteilhafterweise die hochporöse Schicht eine Porosität > 60 %, insbesondere > 70 %, bevorzugt > 80 % aufweist. Hierdurch ergibt sich der Vorteil, dass nur geringfügig mechanische Spannungen übertragen werden und/oder im Falle eines Separierens der Halbleiterschicht von dem Hableitersubstrat die Halbleiterschicht mit geringer Krafteinwirkung und dadurch geringer Bruchgefahr an der hochporösen Schicht vom Halbleitersubstrat abgelöst werden kann.

Die funktionale Zwischenschicht dient als Übergangsschicht zwischen der Porosität der hochporösen Schicht zu der Porosität der Wachstumsvorlageschicht. Vorteilhafterweise nimmt daher die Porosität der funktionalen Zwischenschicht ausgehend von der dem Halbleitersubstrat zugewandten Seite zu der der Halbleiterschicht zugewandten Seite monoton, insbesondere bevorzugt streng monoton, ab.

Die funktionale Zwischenschicht weist bevorzugt einen Unterschied in der Porosität an der dem Halbleitersubstrat zugewandten Seite zu der Porosität an der der Halbleiterschicht zugewandten Seite in Absolutprozent von zumindest 5%, insbesondere zumindest 10% weiter bevorzugt zumindest 20% auf. Hierdurch ergibt sich der Vorteil, dass eine Anpassung an unterschiedliche Gitterkonstanten unter Vermeidung mechanischer Spannungen möglich ist.

Es liegt im Rahmen der Erfindung, dass die funktionale Zwischenschicht als Schichtsystem mit mehreren Lagen unterschiedlicher Porosität ausgebildet ist. Auch hierdurch kann ein vorteilhafter Übergang zwischen der Porosität der hochporösen Schicht und der Porosität der Wachstumsvorlageschicht erzielt werden. Vorteilhafterweise weist die funktionale Zwischenschicht daher zumindest zwei Lagen unterschiedlicher Porosität auf, insbesondere eine Mehrzahl von Lagen mit unterschiedlicher Porosität, bevorzugt eine Mehrzahl von Lagen mit alternierenden Porositäten, welche sich bevorzugt um zumindest 10%, insbesondere zumindest 20% (jeweils Absolutprozent) unterscheiden.

Die Wachstumsvorlageschicht wird bevorzugt mittels Wärmeeinwirkung aus einem dem Halbleitersubstrat abgewandten Teilbereich einer porösen Wachstumsvorlageschicht ausgebildet. Hierdurch ergibt sich eine kostensparende Prozessführung, da nach Ausbilden der porösen Wachstumsvorlageschicht keine weitere Schicht abgeschieden werden muss, sondern ein Randteilbereich der porösen Wachstumsvorlageschicht mittels Wärmeeinwirkung umgewandelt wird in die geschlossene Wachstumsvorlageschicht. Die geschlossene Wachstumsvorlageschicht wird hierbei somit ebenfalls aus dem Material des Halbleitersubstrats ausgebildet und nicht auf das Halbleitersubstrat aufgebracht, insbesondere nicht auf das Halbleitersubstrat abgeschieden.

Die poröse Wachstumsvorlageschicht wird bevorzugt Porosität im Bereich 5% bis 30% und einer Dicke im Bereich 1 nm bis 5 µm, bevorzugt im Bereich 10 nm bis 3 µm ausgebildet.

Vorteilhafterweise erfolgt zum Ausbilden der geschlossenen Wachstumsvorlageschicht eine Erwärmung zumindest des dem Halbleitersubstrat abgewandten Teilbereichs der porösen Wachstumsvorlageschicht auf eine Temperatur von zumindest 600°C, insbesondere bevorzugt eine Temperatur im Bereich 600 °C bis 1200 °C.

Bei der vorteilhaften Ausgestaltung mit Ausbilden der geschlossenen Wachstumsvorlageschicht mittels Wärmeeinwirkung wird die Wärmeeinwirkung zur Ausbildung der geschlossenen Wachstumsvorlageschicht bevorzugt in einer Prozessatmosphäre, welche zumindest eines der Gase aus der Liste Wasserstoff, Argon, Kohlenstoff-enthaltendes Gas, insbesondere Methan, enthält, durchgeführt. Hierdurch ergibt sich der Vorteil, dass gleichzeitig mit Ausbilden der geschlossenen Wachstumsvorlageschicht ein Einlagern eines Stoffes, welchen das Gas der Prozessatmosphäre enthält, in die geschlossene Wachstumsvorlageschicht erfolgt.

In einer kosteneffizienten Ausgestaltung werden die geschlossene Wachstumsvorlageschicht und die Halbleiterschicht in situ ausgebildet. Es wird somit auf ein Aus- und Einschleusen des Halbleitersubstrats bei diesen Prozessschritten verzichtet, sodass die Ausbildung der geschlossenen Wachstumsvorlageschicht und der Halbleiterschicht in derselben Prozesskammer erfolgen.

Vorteilhafterweise wird ein Halbleiterbauelement, insbesondere bevorzugt ein photovoltaisches Halbleiterbauelement wie eine photovoltaische Solarzelle mittels der Halbleiterschicht ausgebildet. Die Halbleiterschicht weist somit ein oder mehrere Halbleiterbauelemente auf. Insbesondere ist es vorteilhaft, dass die Halbleiterschicht mittelbar oder bevorzugt unmittelbar an der geschlossenen Wachstumsvorlageschicht angeordnet ist. Die Verwendung eines solchen Halbleiterbauelementes bzw. solcher Halbleiterbauelemente sieht somit die Benutzung des Halbleiterbauelementes vor, welches an dem Halbleitersubstrat angeordnet ist.

Ebenso liegt es im Rahmen der Erfindung, dass ein Halbleiterbauelement, insbesondere ein photovoltaisches Halbleiterbauelement, mittels der Halbleiterschicht ausgebildet ist und die Halbleiterschicht mechanisch von dem Halbleitersubstrat separiert ist.

Bei dieser Ausführungsform erfolgt somit ein Separieren der Halbleiterschicht von dem Halbleitersubstrat. Die Ausbildung des oder der Halbleiterbauelemente kann vor dem Separieren der Halbleiterschicht oder bevorzugt nach dem Separieren der Halbleiterschicht erfolgen.

Die hochporöse Schicht weist bevorzugt eine Porosität größer 60%, insbesondere größer 70%, bevorzugt größer 80% auf. Hierdurch ergibt sich ein geringes Risiko einer Beeinträchtigung der Materialqualität des Halbleitersubstrats.

Die hochporöse Schicht weist bevorzugt eine Porosität kleiner 95%, insbesondere kleiner 90%, bevorzugt kleiner 80% auf. Hierdurch ergibt sich der Vorteil, dass bereits in der hochporösen Schicht Materialspannungen ohne oder mit zumindest verringerter Materialbeeinträchtigung aufgenommen werden können.

Die poröse Wachstumsvorlageschicht weist bevorzugt eine Porosität kleiner 45%, insbesondere kleiner 40%, bevorzugt kleiner 30% auf. Hierdurch ergibt sich ein geringes Risiko einer Beeinträchtigung der Materialqualität des Halbleitersubstrats.

Die poröse Wachstumsvorlageschicht weist bevorzugt eine Porosität kleiner 10%, insbesondere größer 20%, bevorzugt größer 30% auf.

Die funktionale Zwischenschicht weist bevorzugt eine Porosität im Bereich 0% bis 90%, insbesondere kleiner 80%, bevorzugt im Bereich 10% bis 50% auf.

Die Gitterkonstante der geschlossenen Wachstumsvorlageschicht weicht wie beschrieben bevorzugt um weniger als 5%, insbesondere um weniger als 2%, von der Gitterkonstante der Halbleiterschicht ab. Hierdurch wird das Risiko einer Materialbeeinträchtigung der Halbleiterschicht weiter verringert.

Wie eingangs erwähnt, ermöglicht das erfindungsgemäße Verfahren und die erfindungsgemäße Halbleiterstruktur eine Abscheidung einer von dem Halbleitersubstrat abweichenden Halbleiterschicht, insbesondere mittels Heteroepitaxie. Das Material der Halbleiterschicht weicht daher bevorzugt um zumindest 1 Massenprozent, insbesondere um bevorzugt zumindest 50 Massenprozent von dem Material des Halbleitersubstrat ab. Alternativ oder bevorzugt zusätzlich weist daher das Material der Halbleiterschicht bevorzugt eine zumindest 1 ‰, insbesondere um bevorzugt zumindest 1 % abweichende Gitterkonstante von der Gitterkonstante des Halbleitersubstrats auf.

Weitere vorteilhafte Merkmale und Ausgestaltungen werden im Folgenden anhand der Figuren und eines Ausführungsbeispiels erläutert. Dabei zeigt:

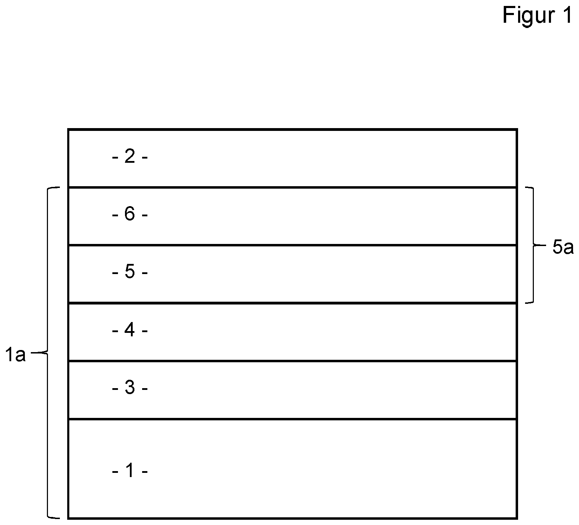

Figur 1     eine schematische Darstellung eines Ausführungsbeispiels einer erfindungsgemäßen Halbleitersubstrat für ein Halbleiterbauelement.

Die Darstellung in Figur 1 zeigt eine schematische, nicht maßstabsgetreue Schnittansicht durch ein Ausführungsbeispiel einer erfindungsgemäßen Halbleiterstruktur für ein Halbleiterbauelement.

Die Halbleiterstruktur weist eine Halbleiterschicht 2 zum Ausbilden einer photovoltaischen Solarzelle auf, welche mittelbar auf einem Halbleitersubstrat 1 angeordnet ist. Die weiteren Zwischenschichten zwischen Halbleitersubstrat 1 und Halbleiterschicht 2 werden nachfolgend anhand eines Ausführungsbeispiels eines erfindungsgemäßen Verfahrens zur Herstellung der Halbleiterstruktur gemäß dem ersten Ausführungsbeispiel erläutert.

Das Halbleitersubstrat 1 ist als Siliziumwafer mit einer Dicke von 500 $\mu$m und einer n-Dotierung ausgebildet, sodass sich ein Schichtwiderstand von 10 m$\Omega$cm ergibt.

Bei Bereitstellen des Halbleitersubstrats weist dieses eine Dicke auf, welche in der schematischen, nicht maßstabsgetreuen Darstellung gemäß Figur 1 der Dicke 1a entspricht.

Nun werden mittels elektrochemischen Ätzen poröse Schichten an der in Figur 1 obenliegend dargestellten Vorderseite des Halbleitersubstrats 1 ausgebildet:

Unmittelbar an dem Halbleitersubstrat 1 wird eine hochporöse Schicht 3 ausgebildet. Diese weist eine Porosität von vorliegend 60 % und eine Dicke von vorliegend 1 $\mu$m auf.

Auf der dem Halbleitersubstrat 1 abgewandten Seite der hochporösen Schicht 3 wird eine funktionale Zwischenschicht 4 ausgebildet. Die funktionale Zwischenschicht 4 weist an der der hochporösen Schicht 3 zugewandten Seite eine Porosität von 60 % und auf der der hochporösen Schicht 3 abgewandten Seite eine Porosität von 30 % auf. Die Porosität der funktionalen Zwischenschicht 4 ändert sich in etwa linear ausgehend von der der hochporösen Schicht 3 zugewandten Seite zu der der hochporösen Schicht 3 abgewandten Seite.

An der dem Halbleitersubstrat abgewandten Seite der funktionalen Zwischenschicht 4 wird eine poröse Wachstumsvorlageschicht 5 ausgebildet. Die poröse Wachstumsvorlageschicht weist eine Porosität von 30 % und eine Dicke von 2,5 $\mu$m auf. Bei Ausbildung der porösen Wachstumsvorlageschicht umfasst diese die in Figur 1 mit 5a gekennzeichnete Dicke, wobei auch hier die Darstellung nicht maßstabsgetreu ist.

Die vorgenannten Schichten werden durch elektrochemisches Ätzen ausgehend von der in Figur 1 obenliegenden Vorderseite erzeugt. Es wird somit beim Ätzvorgang in umgekehrter Reihenfolge die poröse Wachstumsvorlageschicht, dann die funktionale Zwischenschicht, dann die hochporöse Schicht ausgebildet.

Mittels Erhitzen des Halbleitersubstrates 1 und aller porösen Schichten (3-5) wird unter anderem die poröse Wachstumsvorlageschicht 5 in eine geschlossene Wachstumsvorlageschicht 6 ausgebildet, welche eine Porosität < 1 % und eine Dicke von etwa 100 nm aufweist. Bei Erzeugen der geschlossenen Wachstumsvorlageschicht 5 bilden sich alle porösen Schichten somit um und es erfolgt eine Verringerung der Gesamtdicke des Schichtstapels.

Bei dem vorliegenden Ausführungsbeispiel werden die Schichten hochporöse Schicht 3, funktionale Zwischenschicht 4 und poröse Wachstumsvorlageschicht 5 durch elektrochemisches Ätzen in dem Material des ursprünglich bereitgestellten Halbleitersubstrats 1 ausgebildet, dessen Dicke des nicht porösen Volumens somit geringfügig abnimmt, wie in Figur 1 durch den Unterschied zwischen der Dicke 1a und der Dicke des Halbleitersubstrates 1 angedeutet.

Die poröse Wachstumsvorlageschicht 5 wird vorliegend erzeugt, indem das Halbleitersubstrat mit ausgebildeter hochporöser Schicht 3, funktionaler Zwischenschicht 4 und poröser Wachstumsvorlageschicht 5 in einen Epitaxiereaktor eingebracht und aufgeheizt wird. Das Aufheizen erfolgt auf eine für einen nachfolgenden Epitaxieschritt notwendige Temperatur, von vorliegend 1100 -1200°C. Diese Erwärmung vor dem Epitaxieschritt ist vorliegend als sogenannter Pre-Bake-Schritt ausgebildet. Hierbei wird die Oberfläche der Halbleiterstruktur von einem etwaig vorhandenen Oxid befreit und gleichzeitig die Oberflächenstruktur geändert. Durch die Temperatureinwirkung wird die poröse Oberfläche der aller porösen Schichten umgeordnet. Die Wachstumsvorlageschicht 5 wird in der Art umgeordnet, dass sich die Oberfläche schließt und die geschlossene Wachstumsvorlageschicht 6 ausgebildet wird. In einer vorteilhaften Weiterbildung des Ausführungsbeispiels werden zusätzlich bei diesem Schritt Gase in den Prozessraum des Epitaxiereaktors geleitet, um einen Einbau von Stoffen in die geschlossene Wachstumsvorlageschicht 6 zu erzielen. Bei dem vorliegenden Ausführungsbeispiel wird Methan in den Prozessraum des Epitaxiereaktors geleitet, um einen Einbau von Kohlenstoff in die geschlossene Wachstumsvorlageschicht 6 zu erzielen. Die geschlossene Wachstumsvorlageschicht 6 weist daher eine gewünschte, geänderte Gitterkonstante gegenüber dem ursprünglich bereitgestellten Halbleitersubstrat auf.

Die porösen Schichten versuchen den energetisch günstigsten Zustand zu erreichen was zu einer Verzerrung ihres Gitters führt. Das noch vorhandene native Oxid auf der Halbleiteroberfläche baut sich teilweise in das Gitter der porösen Schichten ein und nehme damit auch Einfluss auf die effektive Gitterkonstante. Werden zusätzliche Fremdatome aus der Gasphase (z.B. Kohlenstoff aus dem Methangas) eingebaut wird das Gitter weiter verzerrt und die Gitterkonstante der Wachstumsvorlage weicht immer weiter von jener des Substrats ab. Die poröse Struktur und der Einbau von Fremdatome führt auch zu einer Änderung im thermischen Ausdehnungskoeffizienten.

Eine weitere Möglichkeit eine Anpassung von Gitterkonstanten zu erreichen ist das Wachsen von sogenannten Pufferschichten. Soll auf einem Substrat aus dem Material x eine Schicht aus dem Material y gewachsen werden, so werden mehrere Schichten mitgewachsen, wobei die Konzentration des Materials y mit dem Abstand vom Wafer stetig zunimmt. Gleichzeitig wird die Konzentration des Materials x stetig verringert.

Anschließend wird in situ, das heißt ohne Ausschleusen der Halbleiterstruktur aus dem Prozessraum des Epitaxiereaktors, die Halbleiterschicht 2 epitaktisch erzeugt. Die Halbleiterschicht 2 ist vorliegend als SiC-Schicht ausgebildet (alternativ als Ge-Schicht) und weist somit eine unterschiedliche Gitterkonstante zu dem ursprünglich bereitgestellten Halbleitersubstrat 1 auf, vorliegend beträgt der Unterschied in der Gitterkonstante zwischen Silizium (Halbleitersubstrat) und SiC (Halbleiterschicht) etwa 20%. Da die Gitterkonstante der geschlossenen Wachstumsvorlageschicht jedoch an die zu erzeugende Halbleiterschicht angepasst wurde, weicht die Gitterkonstante der geschlossenen Wachstumsvorlageschicht 6 somit um weniger als 10 % von der Gitterkonstante der Halbleiterschicht 2 ab. Das Risiko einer Materialbeeinträchtigung oder Verringerung der elektronischen Güte der Halbleiterschicht 2 aufgrund von Verspannungen und Kristallfehlern ist somit erheblich verringert gegenüber vorbekannten Herstellungsverfahren.

In einer Abwandlung des beschriebenen Ausführungsbeispiels wird im Herstellungsverfahren auf die poröse Wachstumsvorlageschicht verzichtet. Die geschlossene Wachstumsvorlageschicht 6 wird stattdessen an der dem Halbleitersubstrat 1 abgewandten Seite der funktionalen Zwischenschicht 4 mittels Wärmeeinwirkung wie oben beschrieben und somit aus Material der funktionalen Zwischenschicht 4 ausgebildet.

Im Rahmen dieser Anmeldung stellt die Porosität wie bekannt das Verhältnis von Hohlraumvolumen zu Gesamtvolumen des Materials der jeweiligen Schicht dar. Die prozentuale Porosität berechnet sich aus

$$(1- rho/rho0) * 100\%$$

mit Rohdichte rho, d.h. tatsächlichen Dichte der jeweiligen Schicht und der Reindichte rho0, d.h. der Dichte dieser Schicht im nicht-porösen Zustand.

Bezugszeichenliste

1    Halbleitersubstrat
2    Halbleiterschicht
3    hochporöse Schicht
4    funktionale Zwischenschicht
5    poröse Wachstumsvorlageschicht
6    geschlossene Wachstumsvorlageschicht

**Patentansprüche**

**1.** Verfahren zur Herstellung einer Halbleiterstruktur mit einem Halbleitersubstrat (1) und einer mittelbar auf dem Halbleitersubstrat (1) angeordneten Halbleiterschicht (2),

mit den Verfahrensschritten

I. Bereitstellen des Halbleitersubstrats (1),
II. Ausbilden ein Halbleiterschicht (2) an einer Oberfläche des Halbleitersubstrats (1) mittels Gasphasenabscheidung,

wobei zwischen den Verfahrensschritten I und II an zumindest einer Oberfläche des Halbleitersubstrats (1) zumindest die folgenden Schichten in der Reihenfolge A,B,C1 mit oder ohne Zwischenschaltung weiterer Schichten ausgebildet werden:

A. eine hochporöse Schicht (3) mit einer Porosität größer 50% und einer Dicke im Bereich 0,1 $\mu$m bis 1 $\mu$m,
B. eine funktionale Zwischenschicht (4) mit einer Porosität im Bereich 5% bis 90% und einer Dicke im Bereich 0,1 $\mu$m bis 5 $\mu$m,
C. eine geschlossene Wachstumsvorlageschicht (6) mit einer Porosität kleiner 5%, und einer Dicke im Bereich 1 nm bis 100 nm,

wobei die geschlossene Wachstumsvorlageschicht (6) eine Gitterkonstante aufweist, welche um weniger als 10% von der Gitterkonstante der Halbleiterschicht (2) abweicht,
wobei die Halbleiterschicht (2) auf der geschlossenen Wachstumsschicht - gegebenenfalls unter Zwischenschaltung weiterer Schichten - abgeschieden wird,
dass die Halbleiterschicht (2) mit einer zu dem Halbleitersubstrat (1) um zumindest 1 Massenprozent abweichenden stofflichen Zusammensatzung ausgebildet wird,
dass die Halbleiterschicht (2) mit einer zu dem Halbleitersubstrat (1) abweichenden Gitterkonstante ausgebildet wird und
dass die Halbleiterschicht (2) über die dazwischenliegenden Schichten mit dem Halbleitersubstrat (1) elektrisch leitend verbunden ausgebildet wird und
wobei zumindest die hochporöse Schicht (3), die funktionale Zwischenschicht (4) und die poröse Wachstumsvorlageschicht (5) mittels Ätzen in dem Halbleitersubstrat (1) ausgebildet werden
wobei die Halbleiterschicht (2) als epitaktisch unmittelbar auf die geschlossene Wachstumsvorlageschicht (6) aufgebrachte Schicht ausgebildet wird,
**dadurch gekennzeichnet**
**dass** auf der dem Halbleitersubstrat abgewandten Seite der funktionalen Zwischenschicht (4) mit oder bevorzugt ohne Zwischenschaltung weiterer Schichten eine poröse Wachstumsvorlageschicht (5) mit einer Porosität im Bereich 5% bis 30% und einer Dicke im Bereich 1 nm bis 5 μm, ausgebildet wird und

**dass** die geschlossene Wachstumsvorlageschicht (6) mittels Wärmeeinwirkung aus einem dem Halbleitersubstrat (1) abgewandten Teilbereich der porösen Wachstumsvorlageschicht (5) ausgebildet wird und

**dass** die Wärmeeinwirkung zur Ausbildung der geschlossenen Wachstumsvorlageschicht (6) in einer Prozessatmosphäre, welche zumindest eines der Gase aus der Liste Wasserstoff, Argon, kohlenstoff-enthaltendes Gas, Germanium enthaltendes Gas, enthält, durchgeführt wird.

2. Verfahren nach Anspruch 1,
**dadurch gekennzeichnet,**
**dass** die Wärmeeinwirkung zur Ausbildung der geschlossenen Wachstumsvorlageschicht (6) in einer Prozessatmosphäre, welche Methan enthält, durchgeführt wird.

3. Verfahren nach einem der vorangegangenen Ansprüche 1 oder 2,
**dadurch gekennzeichnet,**
**dass** die Halbleiterschicht (2) epitaktisch abgeschieden wird.

4. Verfahren nach einem der vorangegangenen Ansprüche 1 bis 3,
**dadurch gekennzeichnet,**
**dass** zumindest die hochporöse Schicht (3), die funktionale Zwischenschicht (4) und die poröse Wachstumsvorlageschicht (5) mittels elektrochemischem Ätzen in dem Halbleitersubstrat (1) ausgebildet werden.

## Claims

1. A method for producing a semiconductor structure having a semiconductor substrate (1) and a semiconductor layer (2) which is indirectly arranged on the semiconductor substrate (1), having the steps:

   I. providing a semiconductor substrate (1)
   II. forming a semiconductor layer (2) on a surface of the semiconductor substrate (1) by means of vapor phase deposition,

      wherein between the steps I and II on at least one surface of the semiconductor substrate (1) at least one of the following layers is formed in the sequence A, B, C1 with or without interposition of further layers:

         A. a highly porous layer (3) with a porosity of more than 50% and a thickness of 0.1 μm to 1 μm,
B. a functional intermediate layer (4) with a porosity of 5% to 90% and a thickness of 0.1 μm to 5 μm,
C. a closed growth template layer (6) with a porosity of less than 5% and a thickness of 1 nm to 100 nm,

wherein the closed growth template layer (6) has a grid constant, which deviates by less than 10% from the grid constant of the semiconductor layer (2),
wherein the semiconductor layer (2) is deposited on the closed growth layer - optionally by interposition of further layers -,
the semiconductor layer (2) is formed with a material composition which deviates by at least 1 mass-% from the semiconductor substrate (1),
the semiconductor layer (2) is formed with a grid constant deviating from the semiconductor substrate (1) and
the semiconductor layer (2) is formed electrically conductively connected to the semiconductor substrate (1) via the interposed layers and
wherein at least the highly porous layer (3), the functional intermediate layers (4) and the porous growth template layer (5) are formed in the semiconductor substrate (1) by etching
wherein the semiconductor layer (2) is formed as a layer which is epitaxially applied directly to the closed growth template layer (6),
**characterized in that**
on the side of the functional intermediate layer (4) facing away from the semiconductor substrate a porous growth template layer (5) with a porosity of 5% to 30% and a thickness of 1 nm to 5 μm is formed with or preferably without interposition of further layers and
the closed growth template layer (6) is formed by means of heat exposure from a subarea of the porous growth template layer (5) facing away from the semiconductor substrate (1), and that the heat exposure for forming the closed growth template layer (6) is carried out in a process atmosphere which contains at least one of the gases from the list hydrogen, argon, carbon-containing gas, germanium-containing gas.

2. The method according to claim 1,
**characterized in that**
the heat exposure for forming the closed growth template layer (6) is carried out in a process atmosphere containing methane.

3. The method according to any one of the preceding claims 1 or 2,
**characterized in that**
the semiconductor layer (2) is deposited epitaxially.

4. The method according to any one of the preceding claims 1 to 3,
**characterized in that**
that at least the highly porous layer (3), the functional intermediate layer (4), and the porous growth template layer (5) are formed in the semiconductor substrate (1) by means of electrochemical etching.

## Revendications

1. Procédé destiné à la fabrication d'une structure à semi-conducteurs avec un substrat à semi-conducteurs (1) et une couche à semi-conducteurs (2) disposée indirectement sur le substrat à semi-conducteurs (1), avec les étapes de procédé

I. fourniture du substrat à semi-conducteurs (1),
II. formation d'une couche à semi-conducteurs (2) au niveau d'une surface du substrat à semi-conducteurs (1) au moyen d'un dépôt en phase vapeur,

dans lequel entre les étapes de procédé I et II au niveau d'au moins une surface du substrat à semi-conducteurs (1) au moins les étapes suivantes sont réalisées dans l'ordre A, B, C1 avec ou sans interposition d'autres couches :

A. une couche hautement poreuse (3) avec une porosité supérieure à 50 % et une épaisseur dans la plage de 0,1 $\mu$m à 1 $\mu$m,
B. une couche intermédiaire fonctionnelle (4) avec une porosité dans la plage de 5 % à 90 % et une épaisseur dans la plage de 0,1 $\mu$m à 5 $\mu$m,
C. une couche de base de croissance fermée (6) avec une porosité inférieure à 5 % et une épaisseur dans la plage de 1 nm à 100 nm,

dans lequel la couche de base de croissance fermée (6) présente une constante de réseau qui diverge de moins de 10 % par rapport à la constante de réseau de la couche à semi-conducteurs (2),
dans lequel la couche à semi-conducteurs (2) est déposée en couches sur la couche de croissance fermée, le cas échéant par interposition de couches supplémentaires,
en ce que la couche à semi-conducteurs (2) est formée avec une configuration de matières s'écartant d'au moins 1 pour cent en masse du substrat à semi-conducteurs (1),
en ce que la couche à semi-conducteurs (2) est formée avec une constante de réseau s'écartant du substrat à semi-conducteurs (1) et
en ce que la couche à semi-conducteurs (2) est formée de manière à être reliée électriquement par-dessus les couches intermédiaires au substrat à semi-conducteurs (1)
dans lequel au moins la couche hautement poreuse (3), la couche intermédiaire fonctionnelle (4) et la couche de base de croissance (5) sont formées au moyen d'une gravure dans le substrat à semi-conducteurs (1)
dans lequel la couche à semi-conducteurs (2) est formée en tant que couche appliquée par épitaxie directement sur la couche de base de croissance fermée (6),
**caractérisé en ce**
**que** sur la face de la couche intermédiaire fonctionnelle (4), opposée au substrat à semi-conducteurs, avec ou de préférence sans interposition d'autres couches une couche de base de croissance poreuse (5) avec une porosité dans la plage de 5 % à 30 % et une épaisseur dans la plage de 1 nm à 5 $\mu$m est formée et
en ce que la couche de base de croissance fermée (6) est formée au moyen d'une application de chaleur à partir d'une zone partielle, opposée au substrat à semi-conducteurs (1), de la couche de base de croissance (5) et en ce que l'application de chaleur est réalisée pour la formation de la couche de base de croissance fermée (6) dans une atmosphère de traitement, laquelle contient au moins un des gaz de la liste incluant l'hydrogène, l'argon, un gaz contenant du carbone, un gaz contenant du germanium.

2. Procédé selon la revendication 1,
**caractérisé en ce**
**que** l'application de chaleur destinée à la formation de la couche de base de croissance fermée (6) est réalisée dans une atmosphère de traitement qui contient du méthane.

3. Procédé selon l'une quelconque des revendications précédentes 1 ou 2,
**caractérisé en ce**

**que** la couche à semi-conducteurs (2) est déposée par épitaxie.

4. Procédé selon l'une quelconque des revendications précédentes 1 à 3, **caractérisé en ce qu'**au moins la couche hautement poreuse (3), la couche intermédiaire fonctionnelle (4) et la couche de base de croissance (5) sont réalisées au moyen d'une gravure électrochimique dans le substrat à semi-conducteurs (1).

Figur 1

| | |
|---|---|
| - 2 - | |
| - 6 - | |
| - 5 - | 5a |
| - 4 - | |
| - 3 - | |
| - 1 - | |

1a

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **FEIFEL, MARKUS et al.** Direct growth of III-V/silicon triple-junction solar cells with 19.7% efficiency. *IEEE Journal of Photovoltaics*, 2018, vol. 8 (6), 1590-1595
- **LA VIA et al.** Patterned substrate with inverted silicon pyramids for 3C-SiC epitaxial growth: A comparison with conventional (001) Si substrate. *Journal of Materials Research*, vol. 28 (1), 94-103

- **EVERINO ANDREA et al.** Heteroepitaxial Growth of 3C-SiC on Silicon-Porous Silicon-Silicon (SPS) Substrates. *ECS TRANSACTIONS*, 21 December 2019, vol. 3 (5), 287-298